# DEMANDE DE BREVET EUROPEEN

(11) **EP 2 532 453 A1**
(43) Date de publication de la demande: **12.12.2012**
(21) Numéro de dépôt: 12171012.3
(22) Date de dépôt: 06.06.2012
(51) Int. Cl.: B21D 39/03, F16B 5/00, F16B 17/00, H01L 23/40

(54) **Procédé d'assemblage d'un dissipateur thermique à un composant éléctronique de puissance et machine mettant en oeuvre le procédé**

(30) Priorité: 06.06.2011 FR 1154901
(71) Demandeur: Atlantic Industrie, 85000 La Roche sur Yon (FR)
(72) Inventeur: Laurent, Alexandre, 85500 Beaurepaire (FR)
(74) Mandataire: Chaillot, Geneviève

(57) **Abrégé**

L'invention a pour objet un procédé d'assemblage à un dissipateur thermique (1) d'un composant électronique de puissance (2) du type à trou (6) de montage sur un dissipateur thermique, caractérisé par le fait qu'il comprend les étapes consistant à positionner le composant (2) sur le dissipateur (1) à l'emplacement où le composant (2) doit être fixé, presser l'un contre l'autre le composant (2) et le dissipateur (1), et poinçonner un trou (9) dans le dissipateur (1) à l'aide d'un poinçon (7) de diamètre inférieur à celui dudit trou (6), depuis la face du dissipateur (1) opposée à la face sur laquelle est appliqué le composant (2), de telle sorte que le poinçon (7) perce le dissipateur (1) puis traverse le trou de montage (6), emmenant la matière du dissipateur (1) qui se trouvait à l'endroit du perçage à s'évaser puis à se rabattre contre la bordure du trou (6) opposée au dissipateur (1) à la manière d'un sertissage en vue de l'assemblage mécanique du dissipateur (1) et du composant (2). L'invention porte également sur une machine pour mettre en oeuvre le procédé.

## Description

L'invention concerne, de manière générale, le domaine des cartes électroniques de puissance, par exemple pour des systèmes de chauffage et de ventilation, et porte plus particulièrement sur un procédé d'assemblage mécanique d'un dissipateur thermique à un composant électronique de puissance (notamment de type Triac) et sur une machine associée permettant de mettre en oeuvre le procédé.

La présente invention vise donc à simplifier l'assemblage mécanique d'un dissipateur thermique à un composant électronique de puissance, notamment de type Triac, tout en assurant une bonne transmission thermique entre le composant électronique de puissance et le dissipateur thermique.

Le dissipateur thermique se présente classiquement sous la forme d'une plaque métallique, dont la forme dépend de l'emplacement, sur une carte électronique, du composant électronique de puissance auquel il est associé et de la forme de la carte électronique.

Un composant électronique de puissance dégage en fonctionnement beaucoup de chaleur. Pour un bon fonctionnement du composant électronique de puissance, et pour éviter toute détérioration de celui-ci et de composants voisins sur une carte électronique de puissance sur laquelle il est implanté, il est nécessaire d'assembler à celui-ci un dissipateur thermique permettant d'évacuer la chaleur dégagée en fonctionnement par le composant électronique de puissance.

Les composants électroniques de puissance, notamment ceux de type Triac, possèdent une languette métallique en saillie du boîtier de composant et de même largeur que le boîtier (boîtier de type T0220), la languette étant percée d'un trou pour son assemblage mécanique à un dissipateur thermique.

Les solutions existantes consistent à assembler mécaniquement le dissipateur thermique au composant électronique de puissance par l'intermédiaire d'un rivet, d'un système vis-écrou ou d'un clip, relié au dissipateur thermique et fixé au trou dans la languette percée et solidaire du composant électronique de puissance. A titre d'exemple, dans le système à clip, le clip porte à une extrémité un anneau ouvert avec effet ressort à la fermeture pour se bloquer dans le trou percé dans la languette en saillie du composant électronique de puissance, et est fixé à l'autre extrémité au dissipateur thermique.

Les solutions existantes exposées ci-dessus nécessitent toutes d'ajouter un élément supplémentaire, que ce soit un rivet, un système vis-écrou ou un clip, en plus du composant électronique de puissance et du dissipateur thermique.

Les notices techniques des composants électroniques de puissance recommandent en outre de ne pas créer d'onde de choc dans le composant électronique de puissance.

L'ajout d'un élément supplémentaire engendre des coûts supplémentaires, une consommation de matière supplémentaire et génère des problèmes de gestion des stocks et en conséquence de dépendance vis-à-vis d'un approvisionnement extérieur en pièces mécaniques d'assemblage (rivet, vis-écrou ou clip), de temps d'assemblage long, que ce soit en termes de temps de main d'oeuvre ou de temps machine, et de difficulté d'assemblage. Ainsi, il est parfois difficile d'automatiser cet assemblage.

Il existe également la solution consistant à fixer séparément à la carte électronique d'une part le composant électronique de puissance et d'autre part le dissipateur thermique, de façon à ce que ceux-ci soient en contact.

Cette solution présente les inconvénients des autres solutions exposées ci-dessus, à savoir un besoin en pièces rapportées et une difficulté d'automatisation. Elle présente en outre l'inconvénient de présenter un mauvais contact entre le dissipateur thermique et le composant électronique de puissance qui ne sont pas fixés l'un à l'autre, mais simplement en contact l'un avec l'autre. Une déformation de la carte peut altérer ce contact, et donc diminuer la capacité du dissipateur thermique à refroidir efficacement le composant électronique de puissance.

Afin de résoudre les problèmes décrits ci-dessus présentés par l'état antérieur de la technique, la présente invention porte sur un procédé d'assemblage mécanique d'un dissipateur thermique à un composant électronique de puissance et sur une machine associée permettant de mettre en oeuvre le procédé.

L'assemblage mécanique du composant électronique de puissance au dissipateur thermique consiste à lier mécaniquement les deux éléments, au moins une partie de la surface de la languette percée et en saillie du composant électronique de puissance étant en contact avec une partie plane du dissipateur thermique une fois les deux éléments assemblés, afin d'assurer une conduction thermique entre eux.

Dans le procédé selon l'invention, on presse fortement l'une contre l'autre au moyen d'une plaque d'appui et d'un poinçon la partie plane du dissipateur thermique (sur laquelle sera fixé le composant électronique de puissance) et la languette percée du composant électronique de puissance destinées à être en contact une fois les deux éléments assemblés. Le poinçon déforme localement au niveau de la zone de contact entre les deux éléments la matière d'un ou des deux éléments de façon à les lier intimement.

Il n'y a ainsi plus besoin de pièce rapportée, d'où une économie de matière. Le procédé de la présente invention est également moins sensible aux aléas en approvisionnement, et permet une automatisation, du fait qu'il y a moins de pièces qui entrent en jeu pour mettre en oeuvre le procédé.

Selon une variante préférée, seule la matière constituant le dissipateur thermique est déformée dans le procédé selon l'invention, en étant amenée à passer à travers le trou formé dans la languette percée du composant électronique de puissance par un poinçon de diamètre inférieur au diamètre du trou formé dans la languette percée du composant électronique de puissance, permettant ainsi d'éviter toute détérioration du composant électronique de puissance.

Le poinçon de la machine est avantageusement conique.

La matière du dissipateur thermique emmenée dans le procédé selon l'invention par le poinçon sur les bords du trou formé dans le composante électronique de puissance assure une liaison mécanique entre les deux éléments assemblés, et permet d'éviter l'utilisation d'une pièce rapportée, type rivet, comme dans l'état antérieur de la technique.

La forte pression exercée dans le procédé de l'invention entre les deux surfaces planes des deux éléments garantit une bonne transmission thermique entre les deux éléments.

De la graisse thermique peut en outre être ajoutée entre les deux éléments de façon à améliorer la transmission thermique entre les deux éléments.

La machine mettant en oeuvre le procédé de l'invention doit avoir une vitesse de déplacement du poinçon et une géométrie de celui-ci permettant de limiter les ondes de choc de façon à conserver l'intégrité du composant électronique de puissance. Comme indiqué ci-dessus, le poinçon est, de préférence, conique.

Le procédé de l'invention et la machine associée peuvent être utilisés avec des composants électroniques de puissance sensibles aux chocs et peuvent être facilement automatisés pour des productions de fort volume, de l'ordre du million de pièces par an.

Le procédé de l'invention et la machine associée peuvent être utilisés pour assembler des composants métalliques de faibles dimensions (de l'ordre du cm²).

La présente invention a donc pour objet un procédé d'assemblage à un dissipateur thermique d'un composant électronique de puissance du type de ceux ayant un boîtier comportant un trou de montage sur un dissipateur thermique, caractérisé par le fait qu'il comprend les étapes consistant à :
- positionner le composant électronique de puissance sur le dissipateur thermique à l'emplacement où le composant électronique de puissance doit être fixé ;
- presser l'un contre l'autre le composant électronique de puissance et le dissipateur thermique ;
- poinçonner un trou dans le dissipateur thermique à l'aide d'un poinçon de diamètre inférieur à celui dudit trou, depuis la face du dissipateur thermique opposée à la face sur laquelle est appliqué le composant électronique de puissance, de telle sorte que le poinçon perce le dissipateur thermique puis traverse le trou de montage, emmenant la matière du dissipateur thermique qui se trouvait à l'endroit du perçage à s'évaser puis à se rabattre contre la bordure du trou opposée au dissipateur thermique à la manière d'un sertissage en vue de l'assemblage mécanique du dissipateur thermique et du composant électronique de puissance, la vitesse de déplacement du poinçon étant choisie pour limiter les ondes de choc créées dans le composant électronique de puissance lors du poinçonnage.

La vitesse de déplacement du poinçon peut être comprise entre 0,005 m/s et 0,5 m/s, de manière préférée entre 0,2 m/s et 0,3 m/s.

Ainsi, la faible vitesse de déplacement du poinçon, limitant les ondes de choc lors du poinçonnage dans le composant électronique de puissance, permet de lier le composant électronique de puissance au dissipateur thermique avec une liaison intime et une bonne transmission thermique, tout en économisant des pièces.

De plus, la faible vitesse du poinçon garantit une bonne fiabilité du composant assemblé.

Le procédé peut comprendre en outre une étape facultative d'application de pâte thermoconductible sur le composant électronique de puissance sur sa face destinée à être en contact avec le dissipateur thermique et/ou sur le dissipateur thermique sur sa face destinée à être en contact avec le composant électronique de puissance, avant l'étape de positionnement du composant électronique de puissance sur le dissipateur thermique.

La pâte thermoconductible peut être, par exemple, de la graisse DOW CORNING® de type 340 Heat Sink Compound.

Selon un mode de réalisation préféré, le poinçon est conique. D'autres formes de poinçon permettant d'obtenir un résultat équivalent sont également envisagées dans le cadre de la présente invention.

L'invention a également pour objet une machine d'assemblage d'un dissipateur thermique et d'un composant électronique de puissance du type ayant un boîtier comportant un trou de montage sur un dissipateur thermique, permettant de mettre en oeuvre le procédé d'assemblage défini ci-dessus, caractérisée par le fait qu'elle comprend :
- un vérin ;
- une plaque d'appui, percée d'un trou ;
- un poinçon, le cas échéant conique, apte à être déplacé par le vérin suivant un axe perpendiculaire au plan de la plaque d'appui, le poinçon ayant un diamètre inférieur au diamètre du trou de montage sur un dissipateur thermique du composant électronique de puissance et inférieur au trou formé sur la plaque d'appui et l'axe de déplacement du poinçon par le vérin étant aligné avec le trou formé sur la plaque d'appui de telle sorte que le vérin permet au poinçon de traverser le plan de la plaque d'appui au niveau du trou formé dans celle-ci, la vitesse de déplacement du poinçon étant choisie pour limiter les ondes de choc créées dans le composant électronique de puissance lors du poinçonnage.

La vitesse de déplacement du poinçon peut être comprise entre 0,005 m/s et 0,5 m/s, de manière préférée entre 0,2 m/s et 0,3 m/s.

La machine peut comprendre en outre des éléments de positionnement et de blocage du dissipateur thermique et du composant électronique de puissance.

Le composant électronique de puissance est, de préférence, de type à boîtier solidaire d'une languette métallique dans laquelle est percé le trou de montage du composant, par exemple un boîtier de type TO 220 (« Transistor Outline Package, Case Style 220 » - forme de boîtier de transistor de style 220).

Pour mieux illustrer l'objet de la présente invention, on va en décrire ci-après un mode de réalisation particulier, avec référence au dessin annexé.

Sur ce dessin :
- la Figure 1 est une vue schématique en perspective du composant électronique de puissance et du dissipateur thermique avant l'étape de poinçonnage du procédé de l'invention ; et
- la Figure 2 est une vue schématique en coupe de l'assemblage composant électronique de puissance-dissipateur thermique de la Figure 1 après l'étape de poinçonnage du procédé de l'invention, montrant la plaque d'appui permettant avec le poinçon de presser l'un contre l'autre le dissipateur thermique et le composant électronique de puissance.

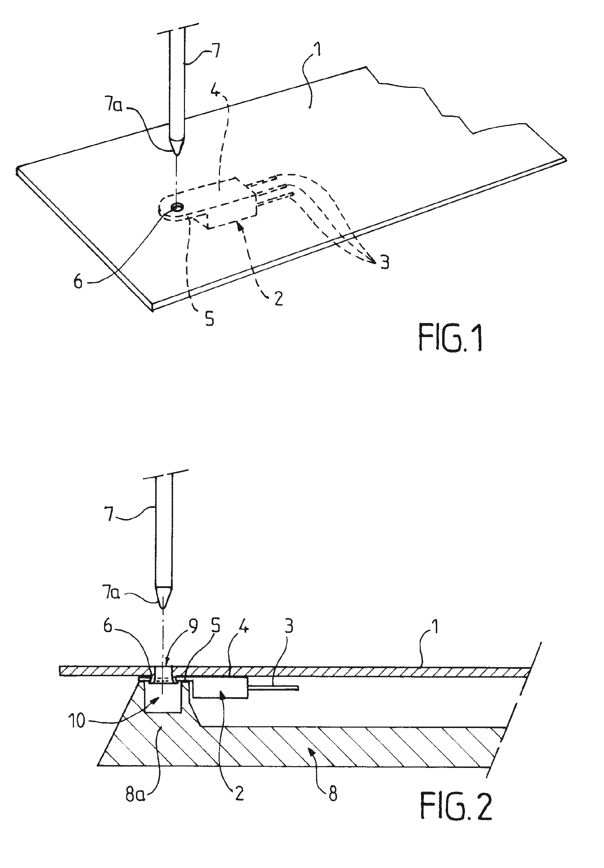

On a représenté schématiquement sur les Figures 1 et 2 un dissipateur thermique 1, sous la forme d'une plaque métallique mince, de préférence en aluminium, et un composant électronique de puissance 2, disposé sous le dissipateur thermique 1.

Le composant électronique de puissance 2 comprend des pattes de fixation 3 sur une carte électronique, un boîtier ou corps 4 et une languette ou semelle 5, en saillie depuis une face du boîtier 4, ladite languette 5 étant percée d'un trou 6. Cette languette 5 permet la transmission vers l'extérieur du composant électronique de puissance 2 de la chaleur générée par le boîtier 4 en fonctionnement.

Dans le procédé selon l'invention, le composant électronique de puissance 2 est plaqué contre le dissipateur thermique 1 par une plaque d'appui 8, de telle sorte que la face du composant électronique de puissance 2 à partir de laquelle s'étend la languette 5 soit appliquée contre le dissipateur thermique 1.

La plaque d'appui 8 est telle qu'elle présente une saillie 8a au sommet de laquelle est formé un trou 10, les bords du trou 10 au sommet de la saillie 8a permettant de presser uniquement la languette 5 du composant électronique de puissance 2 contre le dissipateur thermique 1 et la saillie 8a n'entrant pas en contact avec le boîtier 4 lorsque le composant électronique de puissance 2 est plaqué contre le dissipateur thermique 1, la plaque d'appui 8 étant appliquée sur la face de la languette 5 opposée à celle appliquée contre le dissipateur thermique 1. Le trou 10 permet le passage d'un poinçon 7, qui conjugué à l'action de la plaque d'appui 8, presse l'un contre l'autre le dissipateur thermique 1 et le composant électronique de puissance en vue d'un poinçonnage. Le boîtier 4 du composant électronique de puissance 2 n'est soumis à aucune pression, du fait que la saillie 8a a une hauteur plus importante que l'épaisseur du boîtier 4 et que le boîtier 4 n'est pas en contact avec la saillie 8a, comme on peut le voir sur la Figure 2.

Le poinçon 7, présentant une pointe conique 7a et actionné par un vérin (non représenté) est dirigé vers le dissipateur thermique 1, suivant le même axe que l'axe du trou 6, à l'opposé de la face sur laquelle est appliqué le composant électronique de puissance 2, et perce un trou 9 dans le dissipateur thermique 1, la matière du dissipateur thermique 1 étant emmenée sur les bords du trou 6 de la languette 5 à la manière d'un sertissage afin d'assembler intimement le composant électronique de puissance 2 et le dissipateur thermique 1.

Le composant 2 et le dissipateur thermique 1 peuvent bien entendu être assemblés indifféremment avant ou après que le composant électronique de puissance 2 a été apposé sur une carte électronique.

A titre d'exemple, le dissipateur thermique 1 est en aluminium et d'épaisseur 1,5 mm. Le trou 6 a un diamètre de 3,8 mm (diamètre pour un boîtier T220).

Le poinçon 7 poinçonne un trou de diamètre 1,8 mm dans le dissipateur thermique 1 en aluminium d'épaisseur 1,5 mm.

En utilisation, une pression de l'ordre de 600kg est exercée entre les deux pièces à assembler par la plaque d'appui 8 et le poinçon 7. Cette valeur correspond à l'effort nécessaire d'insertion d'un poinçon conique 7 de diamètre d'environ 3 mm dans le trou du dissipateur thermique 1 de diamètre 1,8 mm, qui emmène la matière du dissipateur thermique 1 dans le trou 6 du composant électronique de puissance 2.

## Revendications

1. Procédé d'assemblage à un dissipateur thermique (1) d'un composant électronique de puissance (2) du type de ceux ayant un boîtier comportant un trou (6) de montage sur un dissipateur thermique, **caractérisé par le fait qu'**il comprend les étapes consistant à :
- positionner le composant électronique de puissance (2) sur le dissipateur thermique (1) à l'emplacement où le composant électronique de puissance (2) doit être fixé ;
- presser l'un contre l'autre le composant électronique de puissance (2) et le dissipateur thermique (1) ;
- poinçonner un trou (9) dans le dissipateur thermique (1) à l'aide d'un poinçon (7) de diamètre inférieur à celui dudit trou (6), depuis la face du dissipateur thermique (1) opposée à la face sur laquelle est appliqué le composant électronique de puissance (2), de telle sorte que le poinçon (7) perce le dissipateur thermique (1) puis traverse le trou de montage (6), emmenant la matière du dissipateur thermique (1) qui se trouvait à l'endroit du perçage à s'évaser puis à se rabattre contre la bordure du trou (6) opposée au dissipateur thermique (1) à la manière d'un sertissage en vue de l'assemblage mécanique du dissipateur thermique (1) et du composant électronique de puissance (2), la vitesse de déplacement du poinçon (7) étant choisie pour limiter les ondes de choc créées dans le composant électronique de puissance (2) lors du poinçonnage.

2. Procédé selon la revendication 1, **caractérisé par le fait que** la vitesse de déplacement du poinçon (7) est comprise entre 0,005 m/s et 0,5 m/s, de manière préférée entre 0,2 m/s et 0,3 m/s.

3. Procédé selon l'une des revendications 1 ou 2, **caractérisé par le fait qu'**il comprend en outre une étape d'application de pâte thermoconductible sur le composant électronique de puissance (2) sur sa face destinée à être en contact avec le dissipateur thermique (1) et/ou sur le dissipateur thermique (1) sur sa face destinée à être en contact avec le composant électronique de puissance (2), avant l'étape de positionnement du composant électronique de puissance (2) sur le dissipateur thermique (1).

4. Procédé selon l'une des revendications 1 à 3, **caractérisé par le fait que** le poinçon (7) est conique.

5. Machine d'assemblage d'un dissipateur thermique (1) et d'un composant électronique de puissance (2) du type ayant un boîtier comportant un trou de montage (6) à un dissipateur thermique, permettant de mettre en oeuvre le procédé d'assemblage selon l'une des revendications 1 à 4, **caractérisée par le fait qu'**elle comprend :
- un vérin ;
- une plaque d'appui (8), percée d'un trou (10) ;
- un poinçon (7), le cas échéant conique, apte à être déplacé par le vérin suivant un axe perpendiculaire au plan de la plaque d'appui (8), le poinçon (7) ayant un diamètre inférieur au diamètre du trou de montage (6) sur un dissipateur thermique du composant électronique de puissance (2) et inférieur au trou (10) formé sur la plaque d'appui (8) et l'axe de déplacement du poinçon (7) par le vérin étant aligné avec le trou (10) formé sur la plaque d'appui (8) de telle sorte que le vérin permet au poinçon (7) de traverser le plan de la plaque d'appui (8) au niveau du trou (10) formé dans celle-ci, la vitesse de déplacement du poinçon (7) étant choisie pour limiter les ondes de choc créées dans le composant électronique de puissance (2) lors du poinçonnage.

6. Procédé selon la revendication 5, **caractérisé par le fait que** la vitesse de déplacement du poinçon (7) est comprise entre 0,005 m/s et 0,5 m/s, de manière préférée entre 0,2 m/s et 0,3 m/s.

7. Machine selon l'une des revendications 5 ou 6, **caractérisée par le fait qu'**elle comprend en outre des éléments de positionnement et de blocage du dissipateur thermique (1) et du composant électronique de puissance (2).
